(19) Europäisches Patentamt
European Patent Office
Office européen des brevets

(11) Veröffentlichungsnummer: **0 292 868**
**A2**

# (12) EUROPÄISCHE PATENTANMELDUNG

(21) Anmeldenummer: **88108017.0**

(51) Int. Cl.4: **G03F 7/10**

(22) Anmeldetag: **19.05.88**

(30) Priorität: **27.05.87 DE 3717933**

(43) Veröffentlichungstag der Anmeldung:
**30.11.88 Patentblatt 88/48**

(84) Benannte Vertragsstaaten:
**BE CH DE FR GB IT LI NL SE**

(71) Anmelder: **HOECHST AKTIENGESELLSCHAFT**
**Postfach 80 03 20**
**D-6230 Frankfurt am Main 80(DE)**

(72) Erfinder: **Hupfer, Bernd, Dr.**
**219 Pinecrest Drive**
**North Kingstown Rhode Island 02852(US)**
Erfinder: **Eckes, Charlotte**
**Erfurter Strasse 53**
**D-6500 Mainz-Gonsenheim(DE)**
Erfinder: **Buhr, Gerhard, Dr.**
**Am Erdbeerstein 28**
**D-6240 Königstein 4(DE)**

## (54) Photopolymerisierbares Gemisch, dieses enthaltendes Aufzeichnungsmaterial und Verfahren zur Herstellung von hochwärmebeständigen Reliefstrukturen.

(57) Es wird ein photopolymerisierbares Gemisch zur Herstellung von Reliefstrukturen aus hochwärmebeständigen Polymeren beschrieben, im wesentlichen aus einem löslichen Präpolymeren, enthaltend esterartig an Carboxylgruppen gebundene lichtempfindliche Reste, Monomere und einen Photoinitiator, welches dadurch ausgezeichnet ist, daß der Photoinitiator mindestens eine Trihalogenmethylgruppe trägt, die unter Einwirkung von Licht reagiert.

Vorteilhaft ist, daß schon nach um den Faktor 4 bis 5 kürzeren Belichtungsdauern - verglichen mit herkömmlichen photopolymerisierbaren Gemischen - kantenscharfe Resistbilder mit einer Auflösung von kleiner 3 µm erhalten werden können.

EP 0 292 868 A2

# Photopolymerisierbares Gemisch, dieses enthaltendes Aufzeichnungsmaterial und Verfahren zur Herstellung von hochwärmebeständigen Reliefstrukturen

Die Erfindung betrifft Photoresists enthaltend esterartig an Carboxylgruppen gebundene ungesättigte Reste tragende, lösliche polymere Vorstufen (Präpolymere), Monomere und Photoinitiatoren zur Ausbildung von Reliefstrukturen aus hochwärmebeständigen Polymeren.

Photoresists zur Ausbildung von Reliefstrukturen aus hochwärmebeständigen Polymeren werden in großem Umfang bei der Herstellung elektrischer und elektronischer Bauelemente, von Ätzresists und Galvanikresists oder von Druckformen verwendet. Photoresists dieser Art werden auf ein Substrat in Form einer Schicht oder Folie aufgetragen, die Schicht oder Folie wird getrocknet und anschließend durch eine Negativvorlage belichtet. An den belichteten Stellen findet eine Vernetzung statt, wodurch sich dort die Löslichkeit drastisch verringert. Die Bereiche, die nicht belichtet wurden, werden in geeigneter Weise durch Herauslösen (Entwickeln) oder Abziehen (peel-apart) entfernt. Die verbleibenden lichtgehärteten Reliefstrukturen können anschließend durch Tempern bei höheren Temperaturen in hochwärme-beständige Polymere überführt werden, die Temperaturen von 250 - 400° C ohne nachteilige Auswirkungen z.B. auf Kantenschärfe und Auflösungsvermögen überstehen.

Gemäß der DE-C-2 308 830 enthalten solche Photoresists lösliche polymere Vorstufen, sogenannte Präpolymere. Diese Präpolymere sind z.B. Polyadditions- oder Polykondensationsprodukte aus carbocyclischen oder heterocyclischen Verbindungen mit zwei zu Polyadditions- oder Polykondensationsreaktionen befähigten funktionellen Gruppen sowie teilweise in ortho- oder peri-Stellung dazu esterartig an Carboxylgruppen gebundenen strahlungsreaktiven Resten (im folgenden Ringverbindungen I genannt) und Diaminen, Diisocyanaten, Bis-säurechloriden oder Dicarbonsäuren, die jeweils mindestens ein cyclisches Strukturelement enthalten (im folgenden Ringverbindungen II genannt). Bei Verwendung der in der DE-C-2 308 830 angeführten Präpolymere sind allerdings 8 - 15 Minuten Belichtung erforderlich, um eine ausreichende Vernetzung der die Präpolymere enthaltenden Photoresists zu gewährleisten. Auch durch Zugabe üblicher Photosensibilisatoren lassen sich diese Zeiten nicht nennenswert verkürzen.

Im Zusatzpatent zu der DE-C-2 308 830, der DE-C-2 437 348, werden die Präpolymere in dem Photoresist dahingehend modifiziert, daß anstelle der dort angegebenen esterartig an Carboxylgruppen gebundenen strahlungsreaktiven Resten, esterartig an Carboxylgruppen gebundene Oxyalkylacrylat- bzw. Oxyalkylmethacrylatgruppen verwendet werden. Hierdurch soll eine Reduzierung der Belichtungszeiten erreicht werden können. Allerdings ist auch die Verwendung derartiger Photoresists für die Massenproduktion elektronischer Bauteile aufgrund immer noch zu langer Belichtungszeiten kritisch.

Eine weitere Steigerung der Lichtempfindlichkeit von Photoresists und eine damit einhergehende Verkürzung der Belichtungszeiten wird in der EP-A-0 047 184 beschrieben, in der zu einem löslichen Amidesterpräpolymeren eine polymerisierbare, polyfunktionelle Acrylatverbindung (Monomeres) und ein aromatischer, ggf. mit Halogen am Kern substituierter Bisimidazol-Photoinitiator hinzugefügt wird. Diese Photoresists zeigen zwar eine gute Lichtempfindlichkeit, der Zusatz von Bisimidazol-Photoinitiatoren hat jedoch Nachteile. So können beispielsweise Bisimidazol-Verbindungen in der Resistlösung zu unerwünschten, vorzeitigen Polyimidbildungen in der Lösung führen, wodurch die Haltbarkeit der Photoresistlösung beträchtlich verringert wird.

Es war daher die Aufgabe der vorliegenden Erfindung, ein photopolymerisierbares Gemisch derart zu modifizieren, daß eine für die Anwendung als Folien und Schichten ausreichende Vernetzung schon nach deutlich kürzeren Belichtungszeiten als bisher üblich erzielt wird, andererseits aber die Stabilität der Photoresistlösung nicht beeinträchtigt wird.

Gelöst wird die Aufgabe durch Bereitstellen photopolymerisierbarer Gemische zur Herstellung von Reliefstrukturen aus hochwärmebeständigen Polymeren der eingangs beschriebenen Gattung, dadurch gekennzeichnet, daß der Photoinitiator mindestens eine Trihalogenmethylgruppe trägt, die unter Einwirkung von Licht reagiert.

Gegenstand der Erfindung ist ferner ein Aufzeichnungsmaterial, bestehend aus einem Träger und einer lichtempfindlichen Schicht, die aus dem erfindungsgemäßen photopolymerisierbaren Gemisch besteht, sowie ein Verfahren zur Herstellung von hochwärmebeständigen Reliefstrukturen aus diesem Aufzeichnungsmaterial.

Die in den erfindungsgemäßen lichtempfindlichen Gemischen (Photoresists) enthaltenen löslichen polymeren Vorstufen entsprechen den üblichen löslichen polymeren Vorstufen, die sich durch Belichtung und gegebenenfalls Tempern in hochwärmebeständige Polymere überführen lassen. Solche löslichen polymeren Vorstufen sind beispielsweise in den DE-C-23 08 830, DE-C-24 37 348, DE-C-24 37 368, DE-C-24 37 422 und der DE-A-32 27 584 beschrieben.

Dabei handelt es sich in der Regel um Polyadditions-bzw. Polykondensationsprodukte aus Ringverbindungen (I), die zwei esterartig an Carboxylgruppen gebundene Gruppen sowie zwei in ortho- oder peri-Stellung dazu angeordnete Carboxyl-, Carbonsäurechlorid-, Amino-, Isocyanat- oder Hydroxylgruppen enthalten, mit Diaminen, Diisocyanaten, Bis-säurechloriden oder Dicarbonsäuren, die mindestens ein cyclisches Strukturelement enthalten (II).

Die Herstellung der in dem photopolymerisierbaren Gemisch enthaltenen löslichen polymeren Vorstufen ist aus der DE-C-2 308 830 und der DE-A-3 227 584 bekannt.

Als esterartig an Carboxylgruppen gebundene strah lungsempfindliche Gruppen werden genannt:

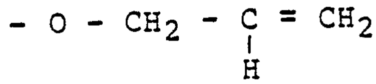

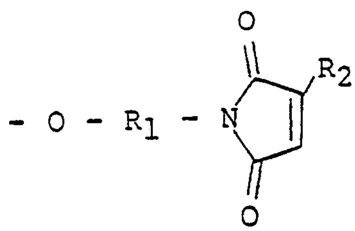

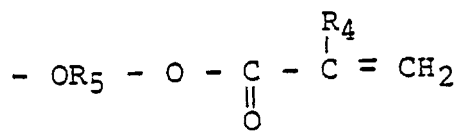

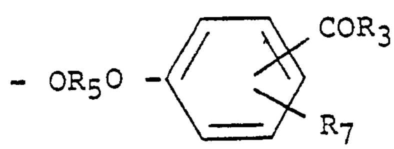

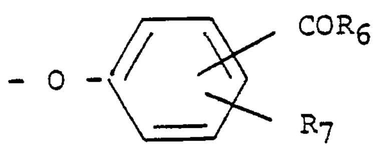

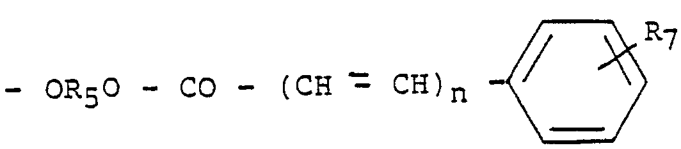

(n = 1,2)

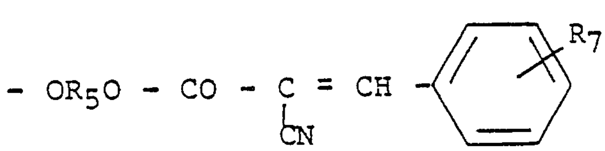

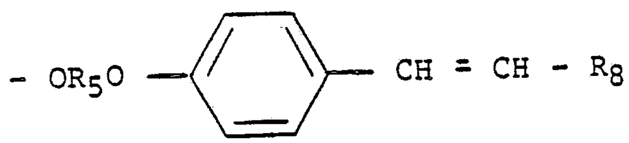

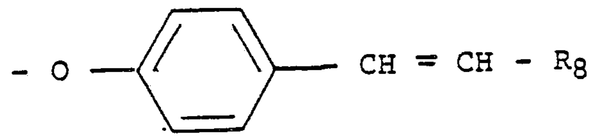

worin

$R_1$ = Alkylen, insbesondere $(C_1-C_6)$Alkylen, Aralkylen, insbesondere Phenyl$(C_1-C_3)$alkylen
$R_2$ = H, $CH_3$, Cl
$R_3$ = Alkyl, insbesondere $(C_1-C_6)$Alkyl, Aralkyl, insbesondere Phenyl$(C_1-C_3)$alkyl
$R_4$ = H, $CH_3$
$R_5$ = Alkylen, insbesondere $(C_1-C_3)$Alkylen
$R_6$ = Alkyl, insbesondere $(C_1-C_3)$Alkyl, Phenyl, Alkoxyphenyl, Halogenphenyl
$R_7$ = H, Cl, Alkyl, Alkoxyl, vorzugsweise mit 1 bis 3 C-Atomen
$R_8$ = carbocycl. oder heterocycl. aromat. Rest, über Ring-C gebunden

bedeuten.

Hervorzuheben von den esterartig an Carboxylgruppen gebundenen strahlungsaktiven Gruppen sind: Oxyallyl-, Oxyalkylacrylat-, Oxyalkylmethacrylat-, N-Oxyalkyl- oder N-Oxyalkylarylmaleinimid-. Besonders bevorzugt werden hiervon Oxyallyl-, 2-Oxyethylacrylat-, 2-Oxyethylmethacrylat- und N-(m-$\beta$-Oxyethoxy)-phenylmaleinimidgruppen, worunter die 2-Oxyethylacrylat- und 2-Oxyethylmethacrylatgruppen eine nochmals bevorzugtere Stellung einnehmen.

Als die strahlungsaktiven Gruppen esterartig bindende Ringverbindungen I werden aliphatische und aromatische Polycarbonsäuren verwendet, die sofern aromatisch, insbesondere mono- oder bicyclisch, aber nicht kondensiert sind. Sie enthalten vorzugsweise vier Carboxylgruppen bzw. ihre Anhydride, Säurehalogenide und/oder Ester (Partialester), stellen aber auch Dihydroxydicarbonsäuren bzw. Diaminodicarbonsäuren, wie bei-spielsweise im Bis(4-hydroxy-3-carboxyphenyl)methan bzw. 4,4′-Diamino-3,3′-dicarboxybiphenyl dar. Tetracarbonsäure-bis-anhydride und Tetracarbonsäure-diesterbis-säurechloride sind bevorzugt. Zu nennen sind hierbei die Bicyclo [2.2.2] octen-(7)-tetracarbonsäure-(2,3,5,6) und deren Derivate oder die Pyromellitsäure, die wegen ihrer leichten Zugänglichkeit und ihrer hohen chemischen Stabilität besonders bevorzugt ist. Sie wird vorzugsweise in Form ihres Dianhydrids für die Synthesen der Präpolymere eingesetzt.

Als Ringverbindungen II kommen erfindungsgemäß alle bisher für diesen Zweck bekannten Diamine, Diisocyanate, Bis-Säurechloride oder Dicarbonsäuren, die mindestens ein cyclisches aromatisches oder heteroaromatisches Strukturelement enthalten, in Frage. Bevorzugt werden mono- oder bicyclische Verbindungen, unter den bicyclischen Verbindungen insbesondere die verbrückten Diphenyle. Als Verbrückungen kommen in Frage: eine Einfachbindung, $-CH_2-$, -NH-, -O-, -S-, $-SO_2-$.

Als lösliche polymere Vorstufen sind besonders bevorzugt Polykondensate aus einer Pyromellitsäure, die zwei esterartig gebundene (Meth)acryloylgruppen enthält, und einem Diamin, beispielsweise 4,4′-Diaminodiphenylether, 4,4′-Diaminodiphenylmethan, 4,4′-Diaminodiphenylsulfon oder 2,4-Diaminopyridin.

Die im erfindungsgemäßen Gemisch enthaltenen polymeren Vorstufen haben in der Regel Molekulargewichte ($M_n$) von 2.000 bis 100.000, vorzugsweise von 4.000 bis 60.000.

Die erfindungsgemäß in den photopolymerisierbaren Gemischen als Photoinitiatoren eingesetzten Trihalogenmethylgruppen enthaltenden Verbindungen sind in der DE-C-2 718 259 und den DE-A-3 337 024, 3 333 450, 2 306 248 und 2 243 621 beschrieben, einschließlich der Methoden zu deren Herstellung.

Es handelt sich um Verbindungen, in denen ein mit Trihalogenmethylgruppen substituiertes aromatisches bzw. heteroaromatisches Ringsystem mit einem weiteren (hetero)aromatischen System in Konjugation treten kann.

Vorzugsweise sind es Verbindungen, in denen ein mit Trihalogenmethylgruppen substituiertes aromatisches bzw. heteroaromatisches Ringsystem direkt über ein ungesättigtes Ring-C-Atom oder über eine Carbonylgruppe mit einem weiteren (hetero)aromatischen System verbunden ist.

Zu nennen sind Trihalogenmethylgruppen enthaltende Verbindungen des Typs A

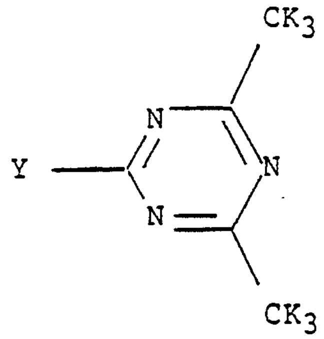

A

worin

Y einen ggf. substituierten aromatischen oder heterocyclischen aromatischen, ggf. über eine konjugierte Alkenylenkette, insbesondere ($C_2$-$C_6$)Alkenylen oder bevorzugt über ein ungesättigtes Ring-C-Atom gebundenen ggf. partiell hydrierten Rest bedeutet.

K ist ein Chlor-, Brom oder Jodatom, vorzugsweise ein Chloratom.

Zu den über eine Alkenylengruppe an ein aromatisches bzw. heteroaromatisches System gebundenen Trihalogenmethylgruppen enthaltenden s-Triazinen gehören z.B. 2-(4-Methoxystyryl)-4,6-bis-trichlormethyl-s-triazin, 2-(4-Dimethylaminophenyl-butadienyl)-4,6-bis-trichlormethyl-s-triazin, 2- [3-(N-Ethyl-benzoxazolyl-2-iden)-propen-1-yl] 4,6-bis-trichlormethyl-s-triazin.

Vorzugsweise haben die Symbole in der oben angegebenen allgemeinen Formel A die folgende Bedeutung:

Y ist ein ggf. partiell hydrierter Aryl-, Aralkenylrest oder ein entsprechender heterocyclischer aromatischer Rest mit 0, S oder N als Heteroatomen, der über ein ungesättigtes Ring-C-Atom gebunden ist. Er kann ebenfalls ein Diphenylrest sein. Die Kerne des Restes Y können einen oder mehrere Substituenten tragen. Ist Aryl ein unsubstituierter Phenylrest, so ist dieser vorzugsweise über eine $C_2$-Alkenylengruppe mit dem trihalogenmethylgruppentragenden s-Triazin verbunden.

Beispiele für geeignete zwei- und dreikernige aromatische Reste sind: Naphthalin, Anthracen, Phenanthren, Chinolin, Isochinolin, Benzofuran, Benzopyran, Dibenzofuran, Benzothiophen, Dibenzothiophen, Acenaphthen, Benzoxazol, Fluoren, Tetrahydrophenanthren und Dihydrophenalen, besonders bevorzugt ist Naphthalin.

Als Substituenten sind z.B. zu nennen:

Halogen, besonders Chlor und Brom, niedere, ggf. substituierte Alkylreste mit vorzugsweise 1 - 3 C-Atomen, ggf. substituierte Arylreste, Nitro-, Sulfonyl-, Alkylmercapto-, Phenylmercapto-, Acyl-, Aryloxy-, Hydroxy- und vorzugsweise Alkoxyreste, besonders bevorzugt ($C_1$-$C_8$)-Alkoxyreste, die wiederum durch Halogen, Phenyl oder Phenoxy substituiert und in denen einzelne Methylengruppen durch O- oder S-Brücken ersetzt sein können, sowie Phenoxy-, Cycloalkoxy- und Alkenyloxyreste.

Besonders bevorzugt werden s-Triazine des Typs A, in denen Y ein Rest der folgenden Formel ist:

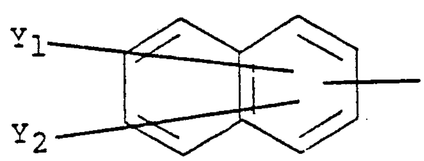

Hierin bedeuten:

$Y_1$ Wasserstoff oder $-OY_3$, bevorzugt $-OY_3$,

$Y_2$ H, Cl, Br, einen niederen Alkyl-, Alkenyl-, Aryl-, einen ggf. substituierten ($C_1$-$C_4$)-Alkoxyrest, besonders bevorzugt Wasserstoff, einen ($C_1$-$C_3$)-Alkyl-oder ($C_1$-$C_3$)-Alkoxyrest und

$Y_3$ einen ($C_1$-$C_8$)-Alkylrest, der durch Halogen, vorzugsweise Chlor oder Brom, Aryl- oder Aryloxyreste substituiert sein kann und in dem einzelne Methylengruppen durch O- oder S-Brücken ersetzt sein können, einen Cycloalkyl-, Alkenyl-
oder Arylrest, insbesondere einen ($C_1$-$C_4$)-Alkyl-
oder Alkoxyalkylrest

oder $Y_1$ und $Y_2$ gemeinsam einen Alkylenrest bedeuten, der vorzugsweise mit dem Naphthalinkern unter Ausbildung eines 5- oder 6-gliedrigen Rings verknüpft ist.

Bevorzugt werden auch Verbindungen, in denen der s-Triazinylrest und ein Alkoxyrest in 1,4- oder 2,6-Stellung des Naphthalinkerns angeordnet sind.

Da durch die Kohlenstoffzahl der Alkoxygruppen die photochemische Aktivität der Initiatoren nur unwesentlich beeinflußt wird, ist die Beschränkung auf acht C-Atome in $-OY_3$ nicht als starre Grenze zu betrachten, sondern kann ggf. durchbrochen werden, beispielsweise mit Nonyloxy-, Dodecyloxy- oder Octadecyloxyresten.

Im einzelnen seien als besonders geeignete Organohalogenverbindungen angeführt:
2-(Naphth-1-yl)-4,6-bis-trichlormethyl-s-triazin,
2-(4-Methoxy-naphth-1-yl)-4,6-bis-trichlormethyl-s-triazin,
2-(4-Ethoxy-naphth-1-yl)-4,6-bis-trichlormethyl-s-triazin,
2-(4-Butoxy-naphth-1-yl)-4,6-bis-trichlormethyl-s-triazin,
2-[4-(2-Methoxyethyl)-naphth-1-yl]-4,6-bis-trichlormethyl-s-triazin,
2-[4-(2-Ethoxyethyl)-naphth-1-yl]-4,6-bis-trichlormethyl-s-triazin,
2-[4-(2-Butoxyethyl)-naphth-1-yl]-4,6-bis-trichlormethyl-s-triazin,
2-(2-Methoxy-naphth-1-yl)-4,6-bis-trichlormethyl-s-triazin,
2-(6-Methoxy-5-methyl-naphth-2-yl)-4,6-bis-trichlormethyl-s-triazin,
2-(6-Methoxy-naphth-2-yl)-4,6-bis-trichlormethyl-s-triazin,
2-(5-Methoxy-naphth-1-yl)-4,6-bis-trichlormethyl-s-triazin,
2-(4,7-Dimethoxy-naphth-1-yl)-4,6-bis-trichlormethyl-s-triazin,
2-(6-Ethoxy-naphth-2-yl)-4,6-bis-trichlormethyl-s-triazin,
2-(4,5-Dimethoxy-naphth-1-yl)-4,6-bis-trichlormethyl-s-triazin und
2-(Acenaphth-5-yl-)-4,6-bis-trichlormethyl-s-triazin sowie auch - mit etwas abgeschwächter Aktivität -
2-(Naphth-2-yl)-4,6-bis-trichlormethyl-s-triazin.

Besonders bevorzugt sind
2-(Alkoxy-naphth-1-yl)-4,6-bis-trichlormethyl-s-triazine, insbesondere
2-(4-Alkoxy-naphth-1-yl)-4,6-bis-trichlormethyl-s-triazine, wie beispielsweise
2-(4-Ethoxy-naphth-1-yl)-4,6-bis-trichlormethyl-s-triazin.

Ebenso besonders bevorzugt sind Verbindungen, in denen $Y_1$ und $Y_2$ gemeinsam einen Alkylenrest bilden, der vorzugsweise mit dem Naphthalinkern unter Ausbildung eines 5- oder 6-gliedrigen Ringes verknüpft ist. Insbesondere ist in diesem Zusammenhang 2-(Acenaphth-5-yl)-4,6-bis-trichlormethyl-s-triazin zu nennen.

Ebenso bevorzugt werden s-Triazine des Typs A, in denen Y ein Rest der folgenden Formel ist:

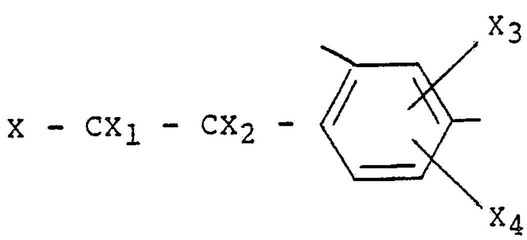

worin
die Phenylgruppe entweder in ortho- oder para-Stellung zur Alkenylengruppe ein trihalogenmethylgruppenhaltiges s-Triazin oder Wasserstoff enthält,
$X_1$ und $X_2$ Wasserstoffatome oder Alkylgruppen bedeuten,
$X_3$ und $X_4$ gleich oder verschieden sind und Wasserstoff- oder Halogenatome, substituierte oder unsubstituierte Alkyl-, Alkenyl- oder Alkoxyreste bedeuten und
X ein substituierter oder unsubstituierter ein- bis dreikerniger aromatischer Rest ist.

Bevorzugt werden Verbindungen, in denen
$X_1$ und $X_2$ Wasserstoffatome oder Methylgruppen, besonders bevorzugt Wasserstoffatome,
$X_3$ ein Wasserstoffatom,
$X_4$ ein Wasserstoff-, Chlor- oder Bromatom, ein Alkylrest mit 1 bis 3 C-Atomen, oder eine Methoxygruppe, besonders bevorzugt ein Wasserstoffatom und
X einen Phenylrest der Formel

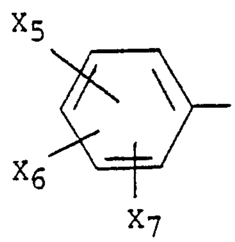

bedeutet,

worin

$X_5$ bis $X_7$ gleich oder verschieden sind und Wasserstoff-oder Halogenatome, die vorzugsweise Fluor, Chlor oder Brom sind, Alkylreste, die unsubstituiert oder durch Halogenatome, vorzugsweise Chlor oder Brom, Aryl- oder Aryloxyreste substituiert sind und in denen einzelne Methylengruppen durch O- oder S-Atome ersetzt sein können und wobei jeweils zwei dieser Reste unter Ausbildung eines 5- oder 6-gliedrigen Rings verknüpft sein können, Cycloalkyl-, Alkenyl-, Aryl- oder Aryloxyreste bedeuten und die Gesamtzahl der C-Atome der Reste $X_5$ bis $X_7$ maximal 12 beträgt.

X kann weiterhin ein Naphthyl-, Acenaphthyl-, Di- oder Tetrahydronaphthyl-, Indanyl-, Anthryl-, Phenanthryl-, Fluorenyl- oder Tetrahydrophenanthrylrest sein, der ggf. durch Halogen-, vorzugsweise Chlor- oder Bromatome, Alkylreste mit 1 bis 3, Alkoxyreste mit 1 bis 4 oder Alkoxyalkylreste mit 3 bis 6 Kohlenstoffatomen substituiert ist.

Besonders bevorzugt sind Verbindungen, worin

$X_1$, $X_2$, $X_3$ und $X_4$, $X_5$ bis $X_7$

Wasserstoffatome bedeuten und gleich oder verschieden sind und Wasserstoff-, Fluor-, Chlor- oder Bromatome, Alkyl-, Alkoxy- oder Alkoxyalkylreste bedeuten oder

$X_5$ ein Wasserstoffatom und

$X_6$ und $X_7$ gemeinsam eine Dioxymethylengruppe

bedeuten.

Im einzelnen kann unter den besonders bevorzugten Verbindungen der Rest X z. B. die folgende Bedeutung haben: Phenyl, 2-, 3- oder 4-Fluorphenyl, 2-, 3- oder 4-Chlorphenyl, 2-, 3- oder 4-Bromphenyl, 2-, 3- oder 4-Methyl-, -Ethyl-, -Propyl-, -Butyl-, -Isobutyl-, -Hexyl-, -Nonyl-oder -Dodecylphenyl, 2-, 3- oder 4-Methoxy-, -Ethoxy-, -Isopropoxy-, -Butoxy-, -Pentoxy-, -Octyloxy- oder -Decyloxyphenyl, 2,4-Dichlor- oder -Dibromphenyl, 3,4-Dichlor- oder -Dibromphenyl, 2,6-Dichlorphenyl, 3-Brom-4-fluorphenyl, 2,3-, 2,4-, 2,5-, 3,4- oder 3,5-Dimethoxy-, -Diethoxy-, -Dibutoxy- oder -Dihexoxyphenyl, 2-Ethoxy-5-methoxyphenyl, 3-Chlor-4-methylphenyl, 2,4-Dimethylphenyl, 2-, 3- oder 4-Methoxyethyl-, -Ethoxyethyl- oder -Butoxyethylphenyl, 2,4,6-Trimethylphenyl, 3,4,5-Trimethoxy- oder -Triethoxyphenyl, 2,3-Dioxymethylen-phenyl oder 3,4-Dioxymethylen-phenyl.

Eine ganz besonders bevorzugte Verbindung ist 2-(4-Styrylphenyl)-4,6-bis-trichlormethyl-s-triazin.

Als erfindungsgemäß in Frage kommende Photoinitiatoren sind weiterhin Verbindungen des Typs B zu nennen

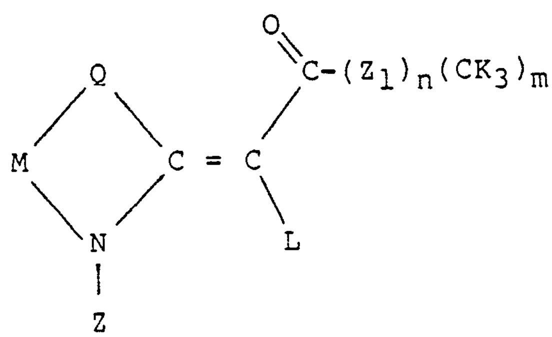

(B)

worin

L ein Wasserstoffatom oder einen Substituenten der Formel $CO-(Z_1)_n(CK_3)_m$,

M einen substituierten oder unsubstituierten Alkylenrest oder Alkenylenrest oder einen 1,2-Arylenrest,

Q ein Schwefel-, Selen- oder Sauerstoffatom, eine Dialkylmethylengruppe, einen Alken-1,2-ylenrest, einen 1,2-Phenylenrest oder eine Gruppe N-R,

wobei M + Q zusammen 3 oder 4 Ringglieder bilden,

Z einen Alkyl-, Aralkyl- oder Alkoxyalkylrest,

$Z_1$ eine carbo- oder heterocyclische aromatische Gruppe,

K ein Chlor-, Brom- oder Jodatom bedeutet und

n = O und m = 1 oder

n = 1 und m = 1 oder 2 ist.

In der Formel des Typs B ist L vorzugsweise ein Wasserstoffatom.

M ist bevorzugt ein 1,2-Phenylenrest, der gegebenenfalls, z. B. durch Halogenatome, Carboxy-, Sulfonsäure-, Nitro-, Cyan-, Carbonyl-, Alkyl-, Aryl-, Alkoxy-, Trifluormethyl- oder Alkoxycarbonylalkylgruppen substituiert sein kann, aber bevorzugt unsubstituiert ist. M kann auch ein heterocyclischer aromatischer Rest, z. B. ein Pyridylenrest, sein. Wenn M ein mehrkerniger Arylrest ist, kann er 2 oder 3, vorzugsweise 2 Benzolkerne enthalten. M kann auch ein 1,2- oder 1,3-Alkenylenrest sein, der gegebenenfalls, z. B. durch Halogenatome, Carboxy-, Carbonyl-, Alkoxy-, Alkyl- oder Arylgruppen, substituiert ist. M kann ferner ein 1,1-, 1,2- oder 1,3-Alkylenrest sein, der auch gegebenenfalls gleichartige Substituenten tragen kann.

Q ist bevorzugt ein Schwefelatom, eine Gruppe NR oder eine Dialkylmethylengruppe mit 3 bis 13, vorzugsweise 3 bis 7, insbesondere 3 Kohlenstoffatomen. Q kann auch ein Sauerstoff- oder Selenatom, eine 1,2-Alkenylengruppe, eine 1,2-Phenylengruppe, eine Carbonyl- oder Thiocarbonylgruppe sein. Wenn Q eine Dialkylmethylengruppe ist, können die Alkylgruppen unter Ausbildung eines 5- oder 6-gliedrigen Rings miteinander verbunden sein. Wenn Q eine 1,2-Alkenylengruppe ist, kann diese u. a. mit einem oder zwei Alkyl- oder Phenylresten, Chloratomen, Alkoxygruppen oder Alkoxycarbonylgruppen substituiert sein; wenn es einen 1,2-Phenylenrest bedeutet, kann dieser als Substituenten z. B. Chloratome, Alkoxy- oder Alkoxycarbonylgruppen enthalten. Besonders bevorzugt ist Q = S, insbesondere als Bestandteil eines fünfgliedrigen Rings.

Wenn Z ein Alkyl- oder Alkoxyalkylrest ist, kann dieser im allgemeinen 1 - 10, bevorzugt 1 - 6 Kohlenstoffatome enthalten. Er kann geradkettig oder verzweigt oder ggf. zu einem cycloaliphatischen Rest, z. B. einem Cyclohexylrest, ringgeschlossen sein. Beispiele für Aralkylreste sind Benzyl-, Chlorbenzyl-, Tolylmethyl- und Phenethylreste. Z ist besonders bevorzugt ein Alkylrest mit 1-3 Kohlenstoffatomen.

$Z_1$ ist eine ein- oder zweikernige, bevorzugt eine einkernige aromatische Gruppe, die vorzugsweise carbocyclisch ist. Beispiele für $Z_1$ sind Benzol-, Naphthalin-, Triazol-, Pyrimidin-, Pyridin-, Oxazol-, Imidazol-, Thiazol-, Oxdiazol, Thiadiazol-, Furan-, Thiophen-, Pyrrol- und Isoxazolringe, die ggf. durch Halogenatome, Alkoxygruppen oder Alkylgruppen substituiert sind.

K ist bevorzugt ein Chlor- oder Bromatom, insbesondere ein Chloratom. Im allgemeinen werden Verbindungen mit n = 1 bevorzugt.

Besonders vorteilhaft ist die Verwendung der Verbindung B1

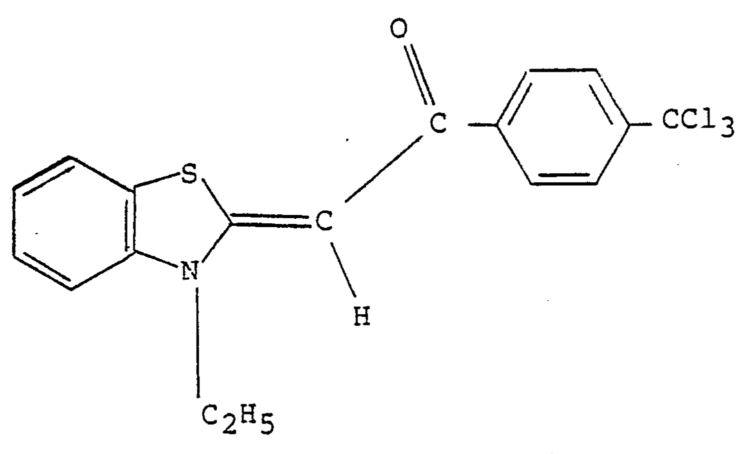

B1

Das lichtempfindliche Gemisch enthält 0,5 bis 30 Gew.-%, vorzugsweise 2 bis 15 Gew.-% (bezogen auf das Gewicht des Präpolymeren) des beschriebenen Photoinitiators.

Erfindungsgemäß enthält das lichtempfindliche Gemisch ferner als Monomere geeignete strahlungsreaktive polymerisierbare polyfunktionelle Acrylverbindungen, insbesondere (Meth)acrylsäureester und -amide. Zu nennen sind Trimethylolpropantrimethacrylat, Trimethylolpropantriacrylat, Trimethylolpropanethoxylattrimethacrylat, Trimethylolpropanethoxylattriacrylat, Trimethylolpropanpolyethoxylattrimethacrylat, Trimethylolpropanpolyethoxylattriacrylat, Pentaerythrittriacrylat, Polyethylenglycoldiacrylat, Triethylenglycoldiacrylat, Polyethylenglycoldimethacrylat, Polymethylendiacrylat, Polymethylendimethacrylat, Trimethylenglycoldimethacrylat oder Mischungen hieraus. Bevorzugt sind Trimethylolpropantriacrylat, Trimethylolpropantrimethacrylat, Pentaerythrittriacrylat sowie Polyethylenglycoldiacrylat.

Das erfindungsgemäße lichtempfindliche Gemisch enthält 5 bis 40 Gew.-%, vorzugsweise 10 bis 30 Gew.-% (bezogen auf das Gewicht des Präpolymeren) mindestens einer der beschriebenen Acrylverbindungen.

Als Lösungsmittel des erfindungsgemäßen photopolymerisierbaren Gemisches eignen sich beispielsweise Ethylenglykol, Glykolether wie Glykolmonomethylether, Glykoldimethylether und Glykolmonoethylether; aliphatische Ester wie Ethylacetat, Hydroxyethylacetat; Alkoxyethylacetat, n-Butylacetat oder Amylacetat; Ether wie Dioxan, Ketone wie Methylethylketon, Methyl-iso-butylketon, Cyclopentanon und Cyclohexanon; Dimethylformamid, Dimethylacetamid, Hexamethylphosphorsäuretriamid, N-Methyl-pyrrolidon, Butyrolacton, Tetrahydrofuran und Mischungen derselben.

Besonders bevorzugt sind Mischungen aus N-Methyl-pyrrolidon und cyclischen Ketonen; insbesondere Cyclopentanon. Die Mischungsverhältnisse liegen vorzugsweise bei 1 : 1 (Gewichtsverhältnisse).

Die mit den übrigen Bestandteilen des photopolymerisierbaren Gemisches entstehenden Lösungen haben in der Regel einen Feststoffgehalt von 5 bis 60 Gew.-%, vorzugsweise bis 50 Gew.-%.

Erfindungsgemäß wird ferner ein lichtempfindiches Aufzeichnungsmaterial beansprucht, im wesentlichen bestehend aus einem Substrat und dem darauf aufgetragenen photopolymerisierbaren Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschichtetem Siliciummaterial zu nennen, die gegebenenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien und Papier. Diese Substratekönnen einer Temperatur-Vorbehandlung unterzogen werden, oberflächlich angerauht, angeätzt oder zur Erhöhung der Hydrophilie mit Chemikalien behandelt sein.

Die auf die genannten Substrate aufgetragenen photopolymerisierbaren Gemische können verschiedene Schichtstärken aufweisen.

Die im Einzelfall vorteilhafteste Schichtstärke hängt von verschiedenen Faktoren ab, beispielsweise dem speziellen Verwendungszweck des herzustellenden Materials, der im Einzelfalle verwendeten polymeren Vorstufe und der Natur der anderen Komponenten, die gegebenenfalls in der strahlungsempfindlichen Schicht zugegen sein können. Als zweckmäßig hat es sich in der Regel erwiesen, wenn die Resistschichten eine Stärke von 0,1 bis 100 $\mu m$, insbesondere 1 bis 10 $\mu m$, aufweisen.

In einer besonderen Ausführungsform kann das lichtempfindliche Aufzeichnungsmaterial zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilan-Typ in Frage, insbesondere ist 3-Aminopropyltriethoxysilan zu nennen.

Gegenstand der Erfindung ist auch ein Verfahren zur Herstellung von hochwärmebeständigen Reliefstrukturen auf einem Substrat. Das Auftragen der lichtempfindlichen photopolymerisierbaren Schicht auf das Substrat kann durch Aufsprühen, Fließbeschichten, Walzen, Schleuderbeschichten und Tauchbeschichten erfolgen. Danach wird das Lösungsmittel durch Verdampfen entfernt, so daß auf der Oberfläche des Substrats die lichtempfindliche Schicht zurückbleibt. Die Entfernung des Lösungsmittels kann gegebenenfalls durch Erhitzen der Schicht auf Temperaturen von bis zu 100 °C gefördert werden. Anschließend wird die Schicht bildmäßig belichtet. Üblicherweise wird aktinisches Licht verwendet, aber auch energiereiche Strahlung wie Röntgen- oder Elektronenstrahlung kommt zur Anwendung, d.h. die Photoinitiatoren sind in jedem Fall auch strahlungsempfindlich. Ebenso sind auch Photoinitiatoren erfindungsgemäß einsetzbar, die nur bei Einwirkung von energiereicher Strahlung wirksam werden (DE-A-2 610 842).

Die Bestrahlung oder Belichtung kann durch eine Maskenvorlage erfolgen, es kann aber auch ein gebündelter Lichtstrahl über die Oberfläche der strahlungsempfindlichen Schicht geführt werden. Üblicherweise werden zur Belichtung UV-Lampen verwendet, die Licht einer Wellenlänge von 200 bis 500 nm mit einer Intensität von 0,5 bis 60 $mW/cm^2$ aussenden. In der lichtempfindlichen Schicht wird anschließend durch Entwicklung ein Bildmuster freigelegt, indem die Schicht mit einer Entwicklerlösung behandelt wird, die die nicht belichteten Bereiche des Photoresistmaterials entfernt.

Als Entwicklerlösung wird in der Regel ein Gemisch aus einem oder mehreren der für die Herstellung des Photoresists angegebenen Lösungsmittel mit einem NichtLösungsmittel verwendet. Typische Entwicklerlösungen sind beispielsweise 4-Butyrolacton/Toluol, Dimethylformamid/Ethanol,

Dimethylformamid/Methanol, Methylethylketon/Ethanol und Methyl-i-butylketon/i-Propanol, jeweils im Verhältnis 2 : 1 bis 1 : 4. Jedoch können auch nur eine Komponente enthaltende Entwickler benutzt werden, worunter Cyclopentanon bevorzugt ist. Nach kurzer Bestrahlungsdauer, die in der Regel mindestens um den Faktor 4 bis 5 kürzer ist als bei den entsprechenden Photoresists ohne den erfindungsgemäßen Zusatz von TrihalogenmethylGruppen enthaltenden Photoinitiatoren und gegebenenfalls ohne die polyfunktionellen Acrylverbindungen, sowie anschließendem Entwickeln, Waschen und Trocknen, werden kantenscharfe Resistbilder mit einer Auflösung von kleiner 3 µm erhalten. Durch Tempern der Resistbilder bei 200 bis 400° C werden die in diesen Bildern enthaltenen Polymere in hochwärmebeständige Polymere überführt. Die gute Auflösung wird durch das Tempern nicht beeinträchtigt.

Die hochwärmebeständigen Polymere haben ausgezeichnete chemische, elektrische und mechanische Eigenschaften. Die erfindungsgemäßen Photoresists eignen sich beispielsweise zur Herstellung von Schutzschichten auf Halbleiterelementen, auf dielektrischen Schichten bei vielschichtigen integrierten Schaltungen, als letzte passivierende Schicht auf elektrischen Vorrichtungen sowie als Orientierungsschicht von Flüssigkristallanzeigezellen. Die folgenden Beispiele erläutern die Herstellung der erfindungsgemäßen Photoresists und ihre Anwendung.

Beispiel 1

a) Photoresist

Es werden
28,8 g polymere Vorstufe (erhalten durch Umsetzung von Pyromellitsäuredianhydrid mit 2-Hydroxyethyl-methacrylat und anschließend mit Thionylchlorid und 4,4'-Diaminodiphenylether gemäß der DE-C-2 437 348, Beispiel 1)
2,8 g Trimethylolpropantrimethacrylat und
1,4 g 2-(4-Styrylphenyl)-4,6-bis-trichlormethyl-s-triazin
in 67,0 g einer Mischung aus N-Methylpyrrolidon und Cyclopentanon (Gewichtsverhältnis 1 : 1) gelöst und durch ein 1 µm-Filter filtriert.

b) Anwendung

(1) Ein mit einer dünnen Siliciumdioxidschicht bedeckter Siliciumwafer (Durchmesser: 75 mm) wird mit einem Aminosilan-Haftvermittler behandelt, indem man eine 0,2 Gew.-%ige Lösung von 3-Aminopropyltriethoxysilan bei 4.000 U/min auf den Wafer aufschleudert und den Wafer 15 min bei 110° C trocknet. Danach wird der Photoresist gemäß a) aufgeschleudert und durch Erwärmen eine Stunde bei 70° C getrocknet. Die erhaltene 2,7 µm dicke Schicht wird anschließend unter Stickstoff im Kontaktverfahren 110 Sekunden durch einen Stufenkeil (Transmission: 1 - 100 %) mit einer 350 W-Quecksilberhochdrucklampe einer Intensität von 6 - 7 mW/cm² (gemessen bei 365 nm) belichtet.

Anschließend werden die nicht belichteten Photoresistteile durch Sprühentwickeln mit Cyclopentanon ausgewaschen. Die verbleibende Resistschichtdicke an den mit verschiedenen Energiemengen belichteten Teilen der Schicht wird gemesen und als %-Anteil der Anfangsschichtdicke gegen die Belichtungsenergie (in mJ/cm²) aufgetragen. Man bestimmt die Lichtempfindlichkeit durch Extrapolation der Belichtungsenergie auf einen %-Anteil der Anfangsschichtdicke von 0 %. Die sich ergebende Belichtungsenergie entspricht dem Empfindlichkeitswert und wird in diesem Beispiel zu 11 mJ/cm² bestimmt.

Der Wafer wird anschließend für zwei Stunden auf 250° C erhitzt. Die von der vollen Belichtungsdosis getroffenen Anteile der Resistschicht weisen nach diesem Schritt eine Dicke von 1,7 µm auf. Dies entspricht einem Wert von 63 % der Anfangsschichtdicke, d.h. der Schichtdicke vor dem Entwickeln.

(2) Ein Siliciumwafer wird wie in Anwendung (1) beschrieben mit dem unter a) aufgeführten Photoresist beschichtet und getrocknet. Der beschichtete Wafer wird anschließend unter Stickstoff im Kontaktverfahren 90 Sekunden durch eine Maske mit einer 350 W-Quecksilberhochdrucklampe belichtet. Die Maske enthält

1, 2, 3 und 4 µm breite Linien, die sich in einem Abstand von 1, 2, 3 und 4 µm befinden. Nach der Belichtung werden die nicht belichteten Photoresistteile durch Sprühentwickeln mit Cyclopentanon ausgewaschen. Man erhält ein kantenscharfes Bild mit einer Auflösung von ca. 1,6 µm.

Beispiel 2

a) Photoresist

Es werden
33,2 g polymere Vorstufe (beschrieben in Beispiel 1)
3,4 g Trimethylolpropantrimethacrylat und
1,7 g 2-(4-Styrylphenyl)-4,6-bis-trichlormethyl-s-triazin
in 61,7 g einer Mischung aus N-Methylpyrrolidon und Cyclopentanon (Gewichtsverhältnis 1 : 1) gelöst und durch ein 1 µm Filter filtriert.

b) Anwendung

Analog zu Beispiel 1 b) wird ein Siliciumwafer mit dem Photoresist beschichtet und getrocknet. Die Schichtdicke beträgt 4,6 µm. Die Belichtungs- und Entwicklungsbedingungen entsprechen denen in Beispiel 1 b): Man erhält einen Empfindlichkeitswert von 17 mJ/cm$^2$. Das Bild ist kantenscharf und zeigt eine Auflösung von 5 µm. Die von der vollen Belichtungsdosis getroffenen Anteile der Resistschicht weisen nach dem Aushärten eine Dicke von 2,7 µm auf.

Beispiele 3 - 5

a) Photoresist

Analog zu Beispiel 1 werden Photoresists hergestellt aus:
28,8 g polymere Vorstufe (beschrieben in Beispiel 1),
2,8 g Trimethylolpropantrimethacrylat und
1,4 g einer der unten genannten Photostarter
in 67,0 g einer Mischung aus N-Methylpyrrolidon und Cyclopentanon (Gewichtsverhältnis 1 : 1). Die erhaltene Lösung wird durch ein 1 µm-Filter filtriert.

Als Photostarter werden eingesetzt:
Beispiel 3: 2-(4-Ethoxy-naphth-1-yl)-4,6-bis-trichlormethyl-s-triazin
Beispiel 4: 2-(Acenaphth-5-yl)-4,6-bis-trichlormethyl-s-triazin
Beispiel 5: Benzothiazolverbindung B1, die die Trichlormethylgruppe über eine Phenylgruppe enthält

b) Anwendung

Bei der Anwendung analog zu Beispiel 1 b) erhält man nach Belichtung von 110 Sekunden und Entwicklung jeweils kantenscharfe Bilder mit einer Auflösung von ca. 3 µm. Bei Verwendung des Stufenkeils aus Beispiel 1 b) und einer Auswertung gemäß Beispiel 1 b) ergeben sich folgende Empfindlichkeitswerte:
Beispiel 3: 14 mJ.cm$^2$

Beispiel 4: 17 mJ/cm²
Beispiel 5: 3 mJ/cm²

In den folgenden Vergleichsbeispielen wurde unter anderem als Photoinitiator Michler's Keton eingesetzt, entsprechend der EP-A-0 047 184 und der DE-A-3 227 584.

## Vergleichsbeispiel 1

Analog zu Beispiel 1 wird ein Photoresist hergestellt, der

28,8 g polymere Vorstufe (beschrieben in Beispiel 1),
2,8 g Trimethylolpropantrimethacrylat und
1,4 g Michler's Keton

in 67,0 g einer Mischung aus N-Methylpyrrolidon und Cyclopentanon (Gewichtsverhältnis 1 : 1) enthält.

Bei der Anwendung analog zu Beispiel 1 b) muß die Belichtungsdauer auf mindestens 1.000 Sekunden erhöht werden, um ein kantenscharfes Bild zu erhalten. Es wird ein Empfindlichkeitswert von 70 mJ/cm² ermittelt.

## Vergleichsbeispiel 2

Analog zu Beispiel 1 wird ein Photoresist hergestellt, der

31,6 g polymere Vorstufe (beschrieben in Beispiel 1) und
1,4 g Michler's Keton

in 67,0 g einer Mischung aus N-Methylpryrrolidon und Cyclopentanon (Gewichtsverhältnis 1 : 1) enthält.

Bei der Anwendung analog zu Beispiel 1 b) muß die Belichtungsdauer auf mindestens 1.200 Sekunden erhöht werden, um ein kantenscharfes Bild zu erhalten. Es wird ein Empfindlichkeitswert von 160 mJ/cm² ermittelt.

## Vergleichsbeispiel 3

Analog Beispiel 1 wird ein Photoresist hergestellt, der

31,6 g polymere Vorstufe (beschrieben in Beispiel 1) und
1,4 g 2-(4-Styrylphenyl)-4,6-bis-trichlormethyl-s-triazin

in 67,0 g N-Methylpyrrolidon/Cyclopentanon (Gewichtsverhältnis 1:1) gelöst enthält.

Bei der Anwendung gemäß Beispiel 1 b) muß die Bestrahlungsdauer auf mindestens 160 Sekunden erhöht werden, um ein kantenscharfes Bild zu erhalten. Es wird ein Empfindlichkeitswert von 37 mJ/cm² ermittelt.

## Ansprüche

1. Photopolymerisierbares Gemisch zur Herstellung von Reliefstrukturen aus hochwärmebeständigen Polymeren, enthaltend eine esterartig an Carboxylgruppen gebundene, ungesättigte Reste tragende, lösliche polymere Vorstufe, ein Monomeres und einen Photoinitiator, dadurch gekennzeichnet, daß der Photoinitiator mindestens eine Trihalogenmethylgruppe trägt, die unter Einwirkung von Licht reagiert.

2. Photopolymerisierbares Gemisch nach Anspruch 1, dadurch gekennzeichnet, daß die lösliche polymere Vorstufe ein Polyadditions- bzw. Polykondensationsprodukt ist.

3. Photopolymerisierbares Gemisch nach den Ansprüchen 1 oder 2, dadurch gekennzeichnet, daß die polymere Vorstufe ein Molekulargewicht ($M_n$) von 2.000 bis 100.000 aufweist.

4. Photopolymerisierbares Gemisch nach einem oder mehreren der Ansprüche 1 bis 3, dadurch gekennzeichnet, daß der Photoinitiator ein mit Trihalogenmethylgruppen substituiertes aromatisches bzw. heteroaromatisches Ringsystem enthält, das mit einem weiteren (hetero)aromatischen System in Konjugation treten kann.

5. Photopolymerisierbares Gemisch nach einem oder mehreren der Ansprüche 1 bis 4, dadurch gekennzeichnet, daß der Photoinitator eine Verbindung des Typs A darstellt,

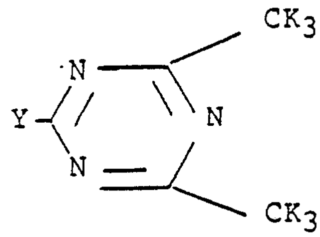

A

worin
Y ein ggf. substituierter aromatischer oder ein heterocyclischer aromatischer, ggf. über eine konjugierte Alkenylenkette, insbesondere ($C_2$-$C_6$) Alkenylen oder bevorzugt über ein ungesättigtes Ring-C-Atom gebundener, ggf. partiell hydrierter Rest, und
K ein Chlor-, Brom- oder Jodatom
bedeutet.

6. Photopolymerisierbares Gemisch nach einem oder mehreren der Ansprüche 1 bis 4, dadurch gekennzeichnet, daß der Photoinitiator eine Verbindung des Typs B darstellt,

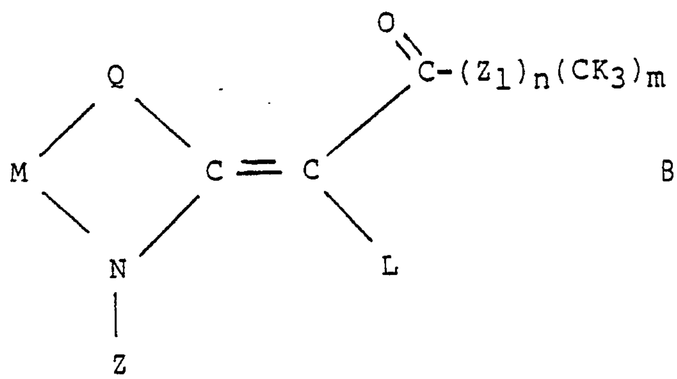

B

worin
L ein Wasserstoffatom oder einen Substituenten der Formel $CO\text{-}(Z_1)_n(CK_3)_m$,
M einen substituierten oder unsubstituierten Alkylenrest oder Alkenylenrest oder einen 1,2-Arylenrest,
Q ein Schwefel-, Selen- oder Sauerstoffatom, eine Dialkylmethylengruppe, einen Alken-1,2-ylenrest, einen 1,2-Phenylenrest oder eine Gruppe N-R,
wobei M + Q zusammen 3 oder 4 Ringglieder bilden,
Z einen Alkyl-, Aralkyl- oder Alkoxyalkylrest,
$Z_1$ eine carbo- oder heterocyclische aromatische Gruppe,
K ein Chlor-, Brom- oder Jodatom bedeutet und
n = 0 und m = 1 oder
n = 1 und m = 1 oder 2 ist.

7. Photopolymerisierbares Gemisch nach einem oder mehreren der Ansprüche 1 bis 6, dadurch gekennzeichnet, daß der Photoinitiator zu 0,5 bis 30 Gew.-%, vorzugsweise zu 2 bis 15 Gew.-%, bezogen auf das Gewicht der polymeren Vorstufe, darin enthalten ist.

8. Photopolymerisierbares Gemisch nach Anspruch 1, dadurch gekennzeichnet, daß das Monomere oder Gemische geeigneter Monomerer zu 10 bis 40 Gew.-%, bezogen auf das Gewicht des Präpolymeren, darin enthalten sind.

9. Photopolymerisierbares Gemisch nach einem oder mehreren der Ansprüche 1 bis 8, dadurch gekennzeichnet, daß das Gemisch ein Lösungsmittel enthält, so daß die entstehende Lösung einen Feststoffgehalt von 5 bis 60 Gew.-%, aufweist.

10. Lichtempfindliches Aufzeichnungsmaterial, im wesentlichen bestehend aus einem Substrat und einer lichtempfindlichen Schicht, dadurch gekennzeichnet, daß die lichtempfindliche Schicht aus einem photopolymerisierbaren Gemisch gemäß einem oder mehreren der Ansprüche 1 bis 9 besteht.

11. Lichtempfindliches Aufzeichnungsmaterial nach Anspruch 10, dadurch gekennzeichnet, daß das Substrat aus einem thermisch oxidierten und/oder mit Aluminium beschichteten Siliciummaterial besteht.

12. Lichtempfindliches Aufzeichnungsmaterial nach Anspruch 10, dadurch gekennzeichnet, daß sich zwischen dem Substrat und der lichtempfindlichen Schicht eine Haftvermittlerschicht befindet.

13. Verfahren zur Herstellung von hochwärmebeständigen Reliefstrukturen, dadurch gekennzeichnet, daß auf ein Substrat ggf. ein Haftvermittler aufgetragen wird, auf dem nach dessen Trocknen das lichtempfindliche photopolymerisierbare Gemisch nach einem oder mehreren der Ansprüche 1 bis 9 aufgebracht wird, daß durch Erhitzen der Schicht auf Temperaturen von bis zu 100° C das Lösungsmittel entfernt wird sowie anschließend bildmäßig belichtet und entwickelt wird.

14. Verfahren nach Anspruch 13, dadurch gekennzeichnet, daß der Entwickler im wesentlichen ein Gemisch aus einem oder mehreren der für die Herstellung des lichtempfindlichen Gemisches benutzten Lösungsmittel mit einem Nicht-Lösungsmittel ist.

15. Verfahren nach Anspruch 13, dadurch gekennzeichnet, daß die Reliefstrukturen nach dem Entwickeln bei Temperaturen von 200 bis 400° C getempert werden.